## Europäisches Patentamt
## European Patent Office
## Office européen des brevets

(19)

(11) Veröffentlichungsnummer: **0 238 712**
A1

(12) # EUROPÄISCHE PATENTANMELDUNG

(21) Anmeldenummer: 86113527.5

(22) Anmeldetag: 01.10.86

(51) Int. Cl.⁴: **H 03 K 17/62**, H 04 Q 3/52

(30) Priorität: 27.01.86 CH 302/86

(43) Veröffentlichungstag der Anmeldung: 30.09.87
Patentblatt 87/40

(84) Benannte Vertragsstaaten: **CH DE FR GB IT LI NL SE**

(71) Anmelder: **SIEMENS-ALBIS AKTIENGESELLSCHAFT, EGA1/Verträge und Patente Postfach, CH-8047 Zürich (CH)**

(72) Erfinder: **Fognini, Bruno, Am Suteracher 3, CH-8048 Zürich (CH)**

(54) **Gesteuerte Umschalter-Matrix.**

(57) Die gesteuerte Umschalter-Matrix umfaßt vier Um-schalter-Bauteile (A, B, A', B') und vier ihnen zugeordnete Signalverteiler (T1, T2, T3; T4, T5, T6; T7, T8, T9; T1, T11, T12). Jeder Signalverteiler ist mit einem Eingangssignal (x, y, z bzw. w) beaufschlagbar, das je einem Eingang der Umschalter-Bauteile (A, B, A', B') zugeführt wird. Die Um-schalter-Bauteile (A, A'; B, B') sind symmetrisch auf beiden Seiten einer Leiterplatte angeordnet. Dadurch ergibt sich eine gute Entkopplung der Signalleitungen untereinander und mit dem Ausgang.

0238712

Unser Zeichen

86P9801

Zürich

Gesteuerte Umschalter-Matrix

Die vorliegende Erfindung betrifft eine gesteuerte Umschalter-Matrix gemäss dem Oberbegriff des Patentanspruches 1.

Zum Herstellen und Auswechseln von elektrischen Verbindungen zwischen den Ausgangsklemmen beliebiger Bauteile und den Eingangsklemmen anderer Bauteile werden oft gesteuerte Umschalter-Matrizen (Switching arrays) eingesetzt. Für Anwendungen bei relativ hohen Frequenzen erweisen sich indessen solche Umschalter-Matrizen als nachteilig im Hinblick auf die Gewährleistung einer ausreichenden Entkopplung zwischen Signalleitungen, die nicht gerade über einen Koppelpunkt miteinander verbunden sind. Es ist daher Aufgabe der vorliegenden Erfindung, eine gesteuerte Umschalter-Matrix zu schaffen, die eine ausreichende Entkopplung zwischen den Signalleitungen, die nicht gerade durchgeschaltet sind, gewährleistet.

Diese Aufgabe wird durch die im kennzeichnenden Teil des Anspruchs 1 umschriebenen Massnahmen gelöst. Vorteilhafte Ausgestaltungen der Erfindung sind in weiteren Ansprüchen angegeben.

Die Erfindung wird nachfolgend anhand von Zeichnungen näher erläutert. Dabei zeigt:

Fig. 1 eine Sicht auf die Ober- und Unterseite einer Leiterplatte, die mit verschiedenen Umschalter-Bauteilen nach einer ersten Ausführung der Erfindung bestückt sind,

Fig. 2 eine Sicht auf die Ober- und Unterseite einer Leiterplatte, die mit verschiedenen Umschalter-Bauteilen nach einer zweiten Ausführung der Erfindung bestückt sind.

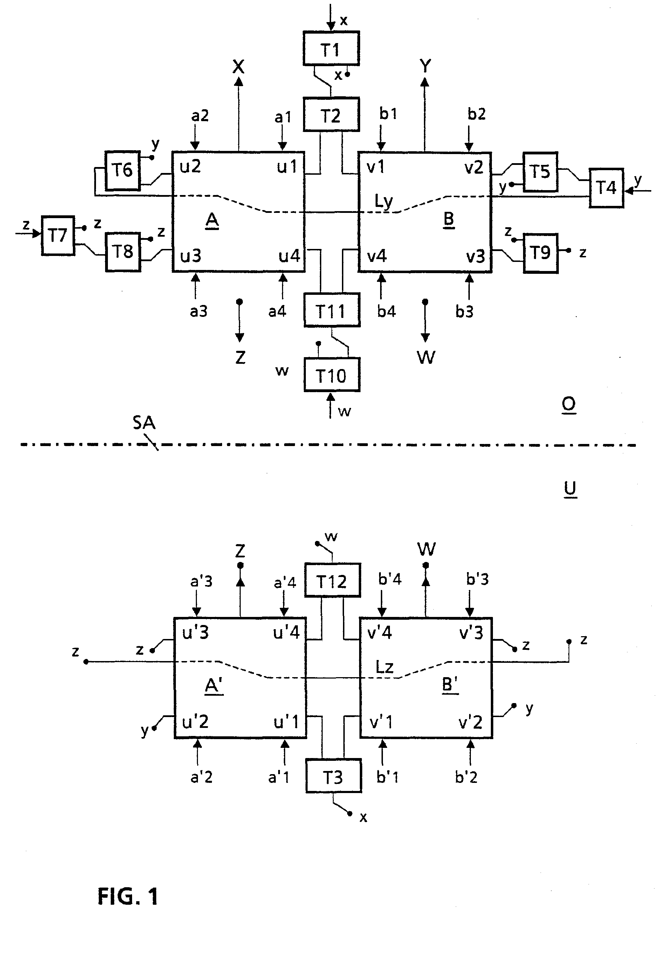

In Fig. 1 sind durch je ein Viereck vier Umschalter-Bauteile A, B, A', B' dargestellt, von denen die zwei ersten auf der oberen Seite O und die zwei anderen genau gegenüberliegend auf der unteren Seite U einer Leiterplatte angeordnet sind. In Fig. 1 sind somit die Vierecke A und A' bzw. B und B' Spiegelbilder voneinander an der Achse SA. Um das Uebersprechen von der einen Leiterplattenseite auf die andere klein

0238712
86P9801

zu halten, sind die Bauteile A, B, A', B' oberflächenmontierbare Bauelemente in SMD-Technik (Surface Mounted Device), die flach auf der Leiterplatte fixiert und anschliessend gelötet werden. In Fig. 1 sind die Steuersignale a1, a2, a3, a4; b1, b2, b3, b4; a'1, a'2, a'3, a'4 und b'1, b'2, b'3, b'4 für die Bauteile A, B, A' bzw. B' angegeben, die entsprechenden Anschlüssen zugeführt werden. Der Bauteil A weist vier Signaleingänge u1, u2, u3, u4 und einen Signalausgang X auf, ebenso der Bauteil B vier Signaleingänge v1, v2, v3, v4 und einen Signalausgang Y, der Bauteil A' vier Eingänge u'1, u'2, u'3, u'4 und einen Ausgang Z und der Bauteil B' vier Eingänge v'1, v'2, v'3, v'4 und einen Ausgang W.

Die Umschalter-Matrix nach Fig. 1 weist vier Signalverteiler mit je drei Signalteilern auf, und zwar einen ersten T1, T2, T3 für ein Eingangssignal x, einen zweiten T4, T5, T6 für ein Signal y, einen dritten T7, T8, T9 für ein Signal z und einen vierten T10, T11, T12 für ein Signal w. Das Signal x wird somit über den ersten Signalverteiler den Eingängen u1, v1, u'1, v'1, das Signal y über den zweiten Verteiler den Eingängen u2, v2, u'2, v'2, das Signal z über den dritten Verteiler den Eingängen u3, v3, u'3, v'3 und das Signal w über den vierten Verteiler den Eingängen u4, v4, u'4, v'4 zugeführt. Bei der Ausführung nach Fig. 1 ist es von Bedeutung, dass der Ausgang des Teilers T4 über eine relativ lange auf der Oberseite O der Leiterplatte geführte Leiterbahn oder Drahtleitung Ly mit dem Eingang des Teilers T6 und der Ausgang des Teilers T7 über eine relativ lange auf der Unterseite U der Leiterplatte geführte Leiterbahn oder Drahtleitung Lz mit dem Eingang des Teilers T9 verbunden ist. Die Leiterbahnen Ly und Lz können beispielsweise unterhalb der Bauteile A und B bzw. der Bauteile A' und B' liegen, und zwar etwa in der Mitte von deren Oberflächen, insbesondere im Raum zwischen den Bauteilen A und B bzw. A' und B'.

Die Umschalter-Matrix gemäss Fig. 1 funktioniert folgendermassen:
Der Bauteil A wird von den Signalen a1, a2, a3 und a4, oder auch von weniger als vier Signalen, derart gesteuert, dass entweder das Signal x vom Eingang u1 oder das Signal y vom Eingang u2 oder das Signal z vom Eingang u3 oder das Signal w vom Eingang u4 zum Ausgang X geführt wird. Entsprechendes gilt für die anderen Bauteile B, A' und B'. An den Ausgängen Z und W sind Durchkontaktierungen von der Unterseite auf die Oberseite der Platte vorgesehen.
Durch diesen speziellen Aufbau und mit einer geeigneten Leiterbahnauslegung ergibt sich der Vorteil, dass eine sehr gute Entkopplung der Signalleitungen untereinander und mit dem Ausgang erreicht wird.

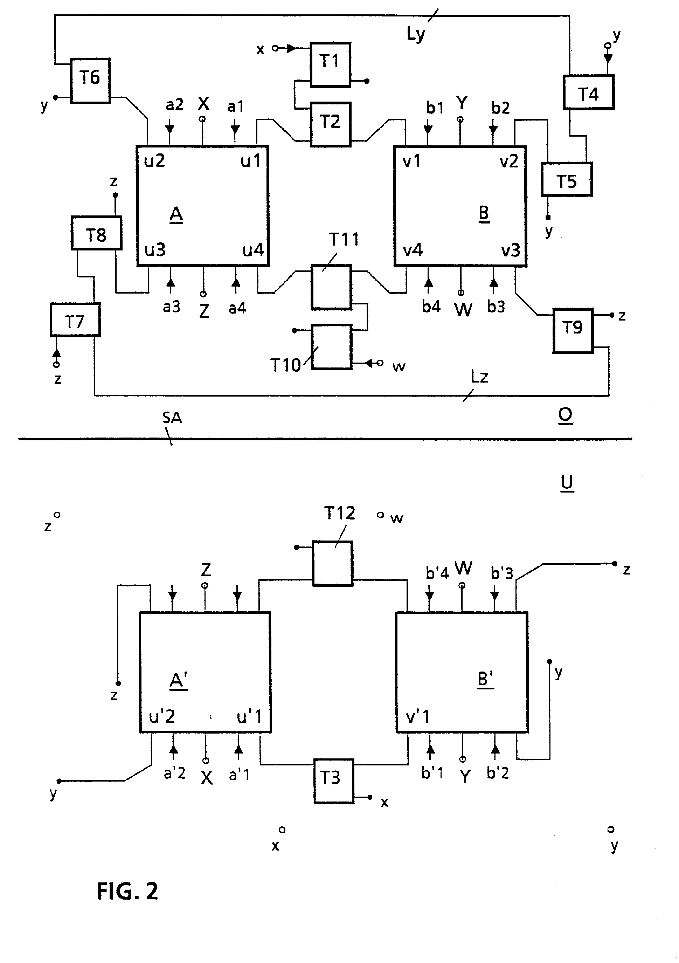

Die Umschalter-Matrix nach Fig. 2 weist eine andere Anordnung mit ähnlichen Elementen wie in Fig. 1 auf, die deshalb gleich bezeichnet sind. In dieser Anordnung ist jedoch die Leiterbahn Ly, die den Ausgang des Signalteilers T4 mit dem Eingang des Signalteilers T6 verbindet, in möglichst grosser Entfernung von allen Elementen und daher fast am Rande der Leiterplatte angeordnet. Entsprechendes gilt für die Leiterbahn Lz, die den Ausgang des Signalteilers T7 mit dem Eingang des Signalteilers T9 verbindet.

Die Umschalter-Matrix nach Fig. 1 oder 2 kann auch mit nur drei Umschalterbauteilen, z. B. A, B, A' arbeiten. In diesem Fall entfallen der Bauteil B und die Teiler T12, T3, T5 und T9, so dass je eine direkte Verbindung zwischen dem Teiler T10 und dem Eingang u1, zwischen dem Teiler T1 und dem Eingang u'1, zwischen dem Teiler T7 und dem Eingang v3 über den Leiter Lz und zwischen dem Teiler T4 und dem Eingang v2 vorgesehen sein muss. Es ist ebenfalls möglich, eine Leiterbahn wie Ly in Fig. 1 oder Fig. 2 mit einer Leiterbahn wie Lz in Fig. 2 bzw. in Fig. 1 vorzusehen.

In der Umschalter-Matrix nach Fig. 1 oder 2 kann mindestens eine der Schichten teilweise eine Massenfläche und teilweise Leiterbahnführungen (Mikrostrip/Koplanar) aufweisen.

Die Umschalter-Matrix nach Fig. 1 oder 2 kann auch eine Mehrschicht-Leiterplatte aufweisen, welche beispielsweise eine mittlere Massenfläche umfasst, die zusammen mit der oberen und unteren Schicht Leitungen in Mikrostrip- bzw. Koplanartechnik (strip line) bildet, oder welche zwei Massenflächen aufweist, zwischen denen eine mittlere Schicht angeordnet ist, die die Leiterbahnen (Triplate-Leitungen) trägt.

PATENTANSPRUECHE

1. Gesteuerte Umschalter-Matrix, bei der die Eingangssignale bis zum Ausgang je eines Umschalter-Bauteils durchschaltbar sind, d a d u r c h g e k e n n z e i c h n e t , dass sie mindestens drei Umschalter-Bauteile (A, B, A') und wenigstens drei ihnen zugeordnete Signalverteiler (T1, T2; T4, T6; T7, T8) umfasst, die mit je einem Eingangssignal (x, y, z) beaufschlagbar sind, die jeweils je einem Eingang der Umschalter-Bauteile (A, B, A') zugeführt werden, und dass mindestens zwei Umschalter-Bauteile (A, A') zumindest annähernd am selben Ort, jedoch auf verschiedenen Seiten einer Leiterplatte angeordnet sind.

2. Umschalter-Matrix nach Anspruch 1, d a d u r c h g e k e n n z e i c h n e t , dass mindestens ein Signalverteiler vorhanden ist, der aus wenigstens zwei getrennten Signalteilern (T4 und T6) besteht, von denen der eine (T4) in der Nähe des Eingangs eines Umschalter-Bauteils (B) und der andere (T6) in der Nähe des Eingangs eines anderen Umschalter-Bauteils (A) angeordnet ist, und dass diese zwei Signalteiler (T4, T6) durch einen Leiter (Ly) verbunden sind.

3. Umschalter-Matrix nach Anspruch 1 oder 2, d a d u r c h g e k e n n z e i c h - n e t , dass die Leiterplatte mehrere Schichten aufweist.

4. Umschalter-Matrix nach Anspruch 3, d a d u r c h g e k e n n z e i c h n e t , dass in der Mehrschicht-Leiterplatte eine Zwischenschicht als Massenfläche vorgesehen ist.

5. Umschalter-Matrix nach einem der Ansprüche 1 bis 4, d a d u r c h g e k e n n - z e i c h n e t , dass die Leiterplatte mit Streifenleitungen (Strip-line) versehen ist.

6. Umschalter-Matrix nach einem der Ansprüche 3 bis 5, d a d u r c h g e k e n n - z e i c h n e t , dass in der Mehrschicht-Leiterplatte mindestens eine Schicht vorhanden ist, die teilweise eine Massenfläche und teilweise Leiterbahnführungen aufweist.

7. Umschalter-Matrix nach einem der Ansprüche 3 bis 6, d a d u r c h   g e k e n n - z e i c h n e t ,   dass die Mehrschicht-Leiterplatte zwei Massenflächen aufweist, zwischen denen eine mittlere Schicht angeordnet ist, die die Leiterbahnen (Triplate-Technik) trägt.

0238712

86P9801

FIG. 1

0238712

86P9801

FIG. 2

0238712

Nummer der Anmeldung

EP 86 11 3527

)) Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 113 046 (GTE LABORATORIES INC.) * Figur 1, Positionen 101-106, 801-806, 11-18; Figur 2; ZUsammenfassung * | 1 | H 03 K 17/62 H 04 Q 3/52 |
| A | US-A-3 504 188 (M.K. FICKER) * Figuren 1-5; Spalte 4, Zeilen 22-32 * | 1 | |
| A | EP-A-0 056 949 (LICENTIA) * Figur 1, Seite 4, Zeile 22 - Seite 5, Zeile 9 * | 3-5,7 | |

| RECHERCHIERTE SACHGEBIETE (Int. Cl.4) |
|---|
| H 03 K 17/16 |
| H 03 K 17/62 |
| H 03 K 17/693 |
| H 04 N 5/268 |
| H 04 Q 3/52 |
| H 05 K 9/00 |

Der vorliegende Recherchenbericht wurde für alle Patentansprüche erstellt.

| Recherchenort | Abschlußdatum der Recherche | Prüfer |
|---|---|---|
| BERLIN | 30-04-1987 | ARENDT M |